# EUROPEAN PATENT APPLICATION

(11) **EP 2 682 950 A1**
(43) Date of publication of application: **08.01.2014**
(21) Application number: 12751879.3
(22) Date of filing: 23.02.2012
(51) Int. Cl.: H01B 7/17, H01B 7/20, H02G 3/04

(54) **SHIELD CONDUCTOR**

(30) Priority: 28.02.2011 JP 2011041708
(71) Applicant: AutoNetworks Technologies, Ltd., Yokkaichi-shi, Mie 510-8503 (JP); Sumitomo Wiring Systems, Ltd., Yokkaichi-shi, Mie 510-8503 (JP); Sumitomo Electric Industries, Ltd., Chuo-ku Osaka-shi Osaka 541-0041 (JP)
(72) Inventor: IZAWA Katsutoshi, Yokkaichi-shi Mie 510-8503 (JP); KUWAHARA Masanori, Yokkaichi-shi Mie 510-8503 (JP); SONODA Fujio, Yokkaichi-shi Mie 510-8503 (JP); ITANI Yasushi, Yokkaichi-shi Mie 510-8503 (JP); SUGIMOTO Yoshinori, Yokkaichi-shi Mie 510-8503 (JP); AOYAMA Naoki, Yokkaichi-shi Mie 510-8503 (JP)
(74) Representative: Winter, Brandl, Fürniss, Hübner, Röss, Kaiser, Polte - Partnerschaft
(86) International application number: PCT/JP2012/054357
(87) International publication number: WO 2012/117924

(57) **Abstract**

A shield conductor 10 includes wires 11, a tubular shield member 20, and a tightening ring 40. The tubular shield member 20 includes a metal pipe 21 and a metal tubular accordion-shaped member 30. An end portion of the pipe 21 is fitted to an end portion of the tubular accordion-shaped member 30. The tubular shield member 20 surrounds the wires 11. The tightening ring 40 is attached to an end portion of the tubular accordion-shaped member 30 to which the end portion of the pipe 21 is fitted, and the end portion of the pipe 21 and the end portion of the tubular accordion-shaped member 30 are tightened up from their outer peripheral side by the tightening ring 40. At least one slit 35 is provided in a portion of the tubular accordion-shaped member 30 that is tightened up the by the tightening ring 40. The slit 35 is cut in from an opening end of the tubular accordion-shaped member 30.

## Description

### TECHNICAL FIELD

The present invention relates to a shield conductor.

### BACKGROUND ART

A shield conductor having a shielding property is used to connect devices such as an inverter and a motor in a vehicle such as an electric vehicle and a hybrid vehicle. Such a shield conductor is described in Patent Document 1. The shield conductor described in Patent Document 1 includes electric wires and tubular shielding means for surrounding collectively the electric wires. The shielding means is mainly configured with a metal pipe, and a connection pipe, a tubular braided member, and a shield shell are sequentially connected to each end of the pipe. The shield shell provided at each end of the shielding means is fixed to a shield casing that accommodates the device such as the inverter, and accordingly, the electric wires connecting the devices are surrounded over their entire peripheries.

### [Patent Document]

[Patent Document 1] Japanese Patent Publication No. 3909763

### DISCLOSURE OF THE INVENTION

### Problem to be solved by the invention

With such a configuration, the tubular braided member is obtained by interweaving thin metal wires in a mesh, and therefore, the tubular braided member may be easy to be hung up by peripheral members during an attachment work. This lowers work efficiency. If the tubular braided member is tore, the shielding property may be deteriorated.

The present invention was accomplished in view of the foregoing circumstances. An object of the present invention is to provide a shield conductor that facilitates a wiring work and improves a shielding property.

### Means for solving problem

According to the present invention, a shield conductor includes a wire, a tubular shield member including a metal pipe and a metal tubular accordion-shaped member, and a tightening ring. The tubular shield member surrounds the wire, and an end portion of the metal pipe is fitted to an end portion of the tubular accordion-shaped member. The tightening ring is provided to a portion of the tubular accordion-shaped member to which the end portion of the pipe is fitted, and configured to tight the end portion of the pipe and the end portion of the tubular accordion-shaped member from an outer peripheral side. The tubular accordion-shaped member has at least one slit in a portion thereof that is configured to be tightened by the tightening ring, and the slit is formed by cutting in from an opening end of the tubular accordion-shaped member.

With such a configuration, compared to the configuration in which the braided wires such as a tubular braided wires formed by interweaving thin metal wires in a mesh is mounted to the end portion of the metal pipe, the wire arrangement work is facilitated and the shielding property is improved. Specifically, the braided wires having good flexibility is often used for the connection portion between the pipe and a device. However, the thin metal wires are easy to come apart especially at the end portions of the braided wires, and the thin metal wires coming apart from the braided wires are easy to be hung up by peripheral members during an attachment work. This may lower work efficiency. The braided wires formed from the thin metal wires is easy to be tore and if the braided wires are tore, the shielding property may be deteriorated.

According to the present invention, the tubular accordion-shaped member is connected to the pipe instead of the braided wires. The tubular accordion-shaped member is configured by extending a metal into a thin metal foil and processing into an accordion shape. Therefore, the end portion of the tubular accordion-shaped member does not come apart, and the tubular accordion-shaped member is not hung up by peripheral members during an attachment work, and this facilitates the wiring work. The tubular accordion-shaped member that is formed with a foil is more excellent in its durability compared to the one formed with the braided wires. Therefore, the tubular accordion-shaped member can surely protect the wires inserted therethrough from being in contact with foreign obstacles or adverse effects of peripheral members. Further, the tough tubular accordion-shaped member achieves the shielding property suitable for the metal pipe and therefore, this improves the shielding property of the whole shielding member.

The tubular accordion-shaped member includes the slit in a portion thereof that is tightened by the tightening ring. The slit is cut in from the opening end of the tubular accordion-shaped member. Due to the effects of the slit, the tubular accordion-shaped member can decrease its diameter so as to follow the outer peripheral surface of the pipe. Accordingly, a larger contact area is ensured and this decreases contact resistance and ensures reliable electrical connection.

In tightening the pipe and the tubular accordion-shaped member with the tightening ring, the tubular accordion-shaped member is easily deformed to follow the outer peripheral surface of the pipe due to the effects of the slits. This improves work efficiency.

The present invention may be configured to be in following forms. The end portion of the tubular accordion-shaped member may be provided radial outer side of the pipe. With this configuration, the end portion of the tubular accordion-shaped member is fitted to the pipe from the radial outer side of the pipe, and this facilitates the operation of fitting the pipe into the tubular accordion-shaped member.

The portion of the tubular accordion-shaped member that is configured to be tightened to an outer periphery of the pipe may include a tubular connecting portion that is formed along the outer periphery of the pipe. With this configuration, a portion of the tubular accordion-shaped member that is clamped to the outer peripheral surface of the pipe is previously formed in a tubular shape, and this improves workability compared to a configuration such a portion of the tubular accordion-shaped member is formed in an accordion shape. Specifically, in tightening the pipe and the tubular accordion-shaped member with the tightening ring, the portion of the tubular accordion-shaped member that is directly in contact with the tightening ring is formed to follow the outer peripheral surface of the pipe. Therefore, a positional gap is less likely to be caused between the tubular accordion-shaped member and the pipe or the tightening ring before and after the tightening. Therefore, the tubular accordion-shaped member is tightened to the pipe surely and this facilitates workability. The tightened portion is formed to follow the outer peripheral surface of the pipe, and this ensures a larger contact area and reduces contact resistance. This also ensures sufficient electrical connection.

A portion of the tubular accordion-shaped member that is provided continuously from the tubular connecting portion may include a tubular seal portion that has a diameter greater than the tubular connecting portion and form a step having a circular gap between the pipe and the tubular seal portion. A seal ring may be provided in the circular gap between the pipe and the tubular seal portion. With this configuration, water or foreign obstacles are less likely to intrude through a space between the pipe and the tubular accordion-shaped member that is clamped.

The slit may extend from the opening end of the end portion of the tubular accordion-shaped member along a longitudinal direction of the tubular accordion-shaped member. The slit may include a plurality of slits and the slits may be provided at equal intervals around a circumferential direction of the opening end of the tubular accordion-shaped member. With this configuration, the opening end of the accordion-shaped member may decrease its diameter evenly.

### Effect of the Invention

The present invention provides a shield conductor that facilitates a wiring work and improves a shielding property.

### BRIEF DESCRIPTION OF THE DRAWINGS

FIG. 1 is a side view illustrating a connection portion connecting a pipe and a tubular accordion-shaped member of a shield conductor according to a first embodiment.
FIG. 2 is a cross-sectional view of the connection portion.
FIG. 3 is a cross-sectional view of the connection portion taken along an A-A line in FIG. 1.
FIG. 4 is a side view of the tubular accordion-shaped member.
FIG. 5 is a cross-sectional view illustrating a connection portion connecting a pipe and a tubular accordion-shaped member of a shield conductor according to a first modification of the first embodiment.
FIG. 6 is a side view of a tubular accordion-shaped member according to a second embodiment.

### MODES FOR CARRYING OUT THE INVENTION

### <First Embodiment>

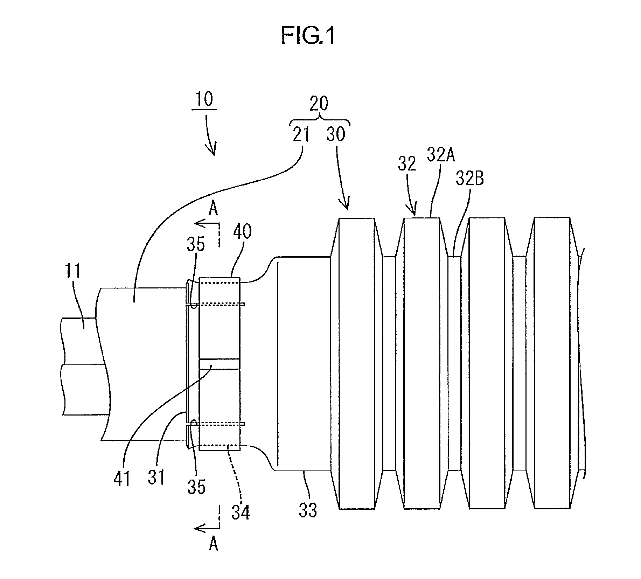

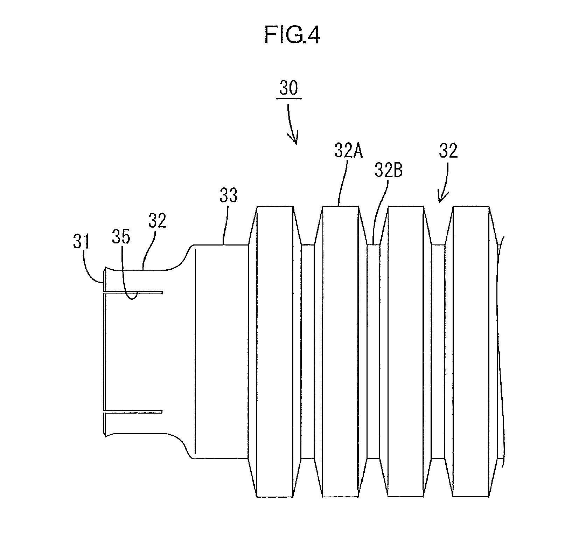

A first embodiment of the present invention will be explained with reference to FIGS. 1 to 4.

A shield conductor 10 of the present embodiment is arranged between devices such as a battery, an inverter and a motor (not illustrated) that configure a power source for running provided in a vehicle such as an electric vehicle. Two electric wires 11 are arranged between the battery and the inverter and three electric wires 11 are arranged between the inverter and the motor. In the present embodiment, the shield conductor 11 including three electric wires 11 that are arranged between the inverter and the motor will be explained. The electric wires 11 are arranged below a floor of a vehicle.

As illustrated in FIG. 1, the shield conductor 10 includes three electric wires 11 and a shield member 20 having a shielding property. The electric wires 11 are inserted through the shield member 20. The shield member 20 includes a pipe 21 that is arranged below the floor of a vehicle and a tubular accordion-shaped member 30 having good flexibility. The tubular accordion-shaped member 30 is electrically connected to each end of the pipe 21 and electrically connects the pipe 20 and the device.

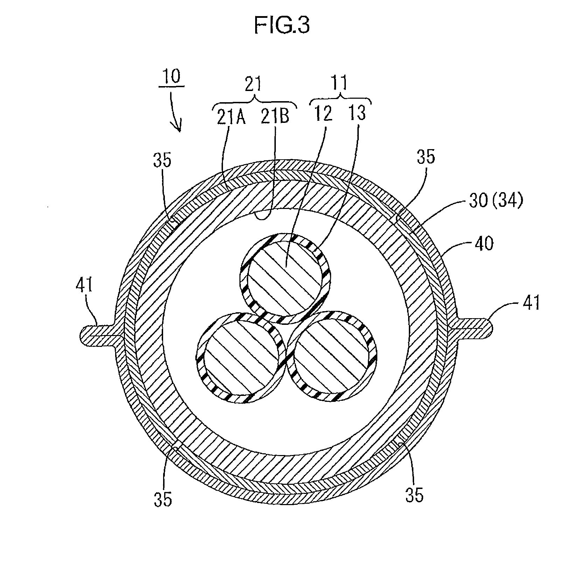

Each electric wire 11 is a covered electric wire having a circular cross section and is configured with a core wire 12 and wire insulation 13 (an insulation layer) surrounding a periphery of the core wire 12, as illustrated in FIG. 3. The core wire 12 is made of copper or copper alloy and is a single core wire or a stranded wire configured with stranded metal wires. As is not illustrated, an end of each of the three electric wires 11 is connected to a terminal connector and the electric wires 11 are passed through the pipe 21 and the tubular accordion-shaped member 30 such that the terminal connector exits from the tubular accordion-shaped member 30 to be connected to a device-side terminal.

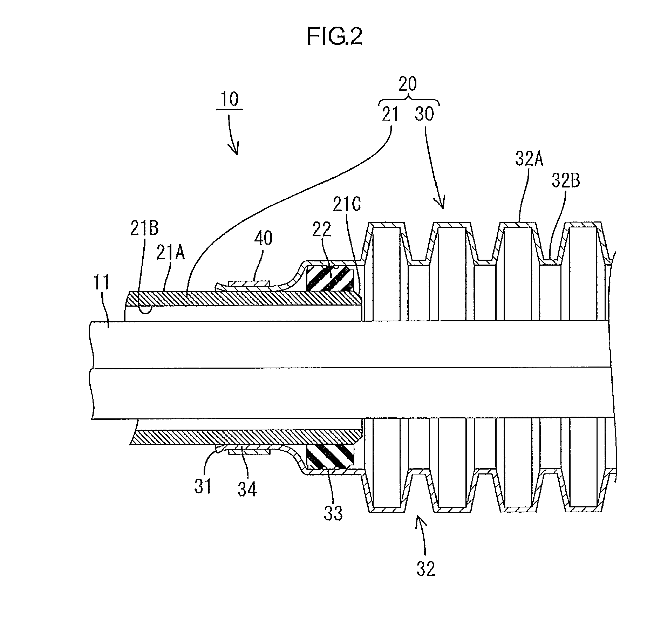

The pipe 21 is formed in a tubular shape and made of metal (such as aluminum or aluminum alloy). The pipe 21 has an inner diameter such that the three electric wires 11 are inserted therethrough. Specifically, as illustrated in FIG. 3, the pipe 21 has an exact circular cross sectional shape and has an outer peripheral surface 21A and an inner peripheral surface 21B that are concentric circles. Namely, a thickness of the pipe 21 is constant over its entire circumference. The outer peripheral surface 21A of the pipe 21 is a smooth curved surface. As illustrated in FIG. 2, a guide inclined surface 21C is formed at an opening edge of the pipe 21. The guide inclined surface 21 is inclined from the outer peripheral surface 21A to decrease an outer diameter of the pipe 21 as is close to the opening edge. The pipe 21 is easily and smoothly inserted to an O-ring 22 (corresponding to a seal ring) and the tubular accordion-shaped member 30 due to the effects of the guide inclined surface 21. The O-ring 22 is fitted to the outer periphery of the pipe 21 and the tubular accordion-shaped member 30 surrounds the outer periphery of the O-ring 22. The pipe 21 having such a configuration has a shielding property and also has a protection property of protecting the electric wires 11. Such a pipe 21 is suitable to be arranged below the floor of a vehicle because the electric wires 11 may be likely to be damaged below the floor.

An end portion of the pipe 21 is fitted to an end portion of the tubular accordion-shaped member 30. Specifically, the end portion of the pipe 21 is inserted into the tubular accordion-shaped member 30 through an opening end 31. Namely, the end portion of the tubular accordion-shaped member 30 is arranged on a radial outer side of the pipe 21 at the end portion of the pipe 21. A fitting portion in which the end portion of the pipe 21 is fitted to the end portion of the tubular accordion-shaped member 30 is clamped with a clamp ring 40 (corresponding to a clamp ring) from an outer peripheral surface. Accordingly, the pipe 21 is electrically connected to the tubular accordion-shaped member 30.

The tubular accordion-shaped member 30 is made of metal (such as copper, copper alloy that are excellent in flexibility) and formed by deforming a thin foil into an accordion shape. As illustrated in FIGS. 1 to 4, the tubular accordion-shaped member 30 is formed in substantially a tubular shape as a whole, and a portion having the accordion shape is a main body 32. As illustrated in FIG. 2, a tubular seal portion 33 and a tubular connecting portion 34 are provided between the main body 32 and the opening end 31. The tubular seal portion 33 is provided continuously from the main body 32 side and the tubular connecting portion 34 is provided at the opening end 31 side. As will be described in detail later, the tubular seal portion 33 surrounds the outer periphery of the O-ring 22 to be contacted closely. The O-ring 22 is fitted to the pipe 21. The tubular connecting portion 34 is clamped with the clamp ring 40 from its outer peripheral side.

The main body 43 includes a plurality of projections 32A that are provided along an axial direction of the main body 32 at predetermined intervals. Each of the projections 32A projects toward an outer periphery of the main body 32 and extends in a circumferential direction of the main body 32. A recess 32B is formed between the projections 32A and is recessed toward an inner periphery of the main body 32. The projections 32A and the recesses 32B are arranged alternately to form an accordion shape and with this configuration, the main body 32 has flexibility that can deal with flexibility of wiring arrangement of the electric wires 11.

The tubular seal portion 33 has a diameter greater than the tubular connecting portion 34 and forms a step. A gap is generated between the tubular seal portion 33 and the outer peripheral surface 21A of the pipe 21 so as to extend in a circular shape. A size of the gap corresponds to a thickness of the O-ring 22. As illustrated in FIG. 2, the O-ring 22 that is fitted to the outer peripheral surface 21A of the pipe 21 is fitted to the gap. The O-ring 22 is made of an elastic member such as rubber and closely adheres to the inner peripheral surface of the tubular seal portion 33 and the outer peripheral surface 21A of the pipe 21 so as to closely seal a space between the tubular seal portion 33 and the pipe 21.

The tubular connecting portion 34 is formed to have a size substantially same as an outer diameter of the pipe 21 and extends from the opening end 31 along the outer peripheral surface 21A. The outer peripheral surface of the tubular connecting portion 34 is a smooth curved surface. Four slits 35 are cut in the tubular connecting portion 34 from the opening end 31 along a longitudinal direction of the tubular connecting portion 34 (the tubular accordion-shaped member 30). The slits 35 are formed in the tubular connecting portion 34 at equal intervals around a circumferential direction of the opening end 21 and each of the slits 35 extends from the opening end 31. A length of the slit 35 extending along the longitudinal direction of the tubular connecting portion 34 is set such that the slit 35 extends from the opening end 31 through the tubular connecting portion 34 to a border portion in which the diameter of the tubular connecting portion 34 increases toward the tubular seal portion 33.

The clamp ring 40 that clamps the tubular connecting portion 34 and the pipe 21 is made of metal (such as aluminum alloy, stainless, copper, copper alloy and the like) and formed in a ring shape. The clamp ring 40 is formed in a belt-like shape extending in its axial direction and has a width that is substantially equal to a width of the tubular connecting portion 34 of the tubular accordion-shaped member 30. The clamp ring 40 has an inner diameter that is greater than an outer diameter of the pipe 21 before clamping.

Next, a process of clamping the tubular accordion-shaped member 30 with the clamp ring 40 from an outer periphery of the pipe 21 will be explained.

First, the O-ring 22 is fitted to the pipe 21 and the pipe 21 to which the O-ring 22 is fitted is inserted from the guide inclined surface 21C side through the opening end 31 of the tubular accordion-shaped member 30. The pipe 21 is inserted until the O-ring 22 reaches the tubular seal portion 33 of the tubular accordion-shaped member 30, and the O-ring 22 is adhered closely to the inner surface of the tubular seal portion 33 and the outer surface of the pipe 21 and seals a space therebetween. In this state, the clamp ring 40 is fitted to the tubular connecting portion 34. The clamp ring 40 is positioned on the tubular connecting portion 34 of the tubular accordion-shaped member 30. In such a state, the pipe 21, the tubular connecting portion 34 of the tubular accordion-shaped member 30, and the clamp ring 40 are overlapped with each other concentrically from an axial center in this order.

The pipe 21, the tubular accordion-shaped member 30 and the clamp ring 40 that are overlapped with each other are set in a mold for clamping (not illustrated). If the mold is clamped, the clamp ring 40 is pressed toward the tubular connecting portion 34 of the tubular accordion-shaped member 30, and the tubular connecting portion 34 is deformed to decrease its diameter with the clamp ring 40 so as to follow the outer peripheral surface 21A of the pipe 21 due to the effects of the slits 35 formed in the tubular connecting portion 34. As illustrated in FIG. 3, an extra portion of the clamp ring 40 that is generated by the deformation is projected to outer side and ear-like portions 41 are formed on opposite sides. The ear-like portion 41 is formed by folding the extra portion and closely adhering inner surfaces of the folded extra portion. A portion of the clamp ring 40 other than the ear-like portions 41 is closely adhered to the outer peripheral surface 21A of the pipe 21 to which the tubular connecting portion 34 is closely adhered. The portion of the clamp ring 40 other than the ear-like portions 41 is formed in substantially a circle. Thus, the tubular accordion-shaped member 30 is clamped evenly in its radial direction between the outer peripheral surface 21A of the pipe 21 and the inner surface of the clamp ring 40 and electrically connected to the pipe 21.

As is explained before, according to the present embodiment, the shield member 20 surrounding the electric wires 11 includes the metal pipe 21 and the metal tubular accordion-shaped member 30. The metal pipe 21 is fitted to the metal tubular accordion-shaped member 30 and the end portion of the pipe 21 and the end portion of the tubular accordion-shaped member 30 are fitted to each other and are clamped with the clamp ring 40 from an outer side. Compared to the known configuration in which braided wires such as the tubular braided member are attached, the configuration of the present embodiment facilitates the wiring work and improves the shielding property.

The braided wires are formed by interweaving thin metal wires in a mesh. Therefore, the thin metal wires are easy to come apart especially at the end portions of the braided wires, and the thin metal wires coming apart from the braided wires are easy to be hung up by peripheral members during an attachment work. This may lower work efficiency. The braided wires formed from the thin metal wires is easy to be tore and if the braided wires are tore, the shielding property may be deteriorated.

According to the present embodiment, the tubular accordion-shaped member 30 is connected to the pipe 21 instead of the braided wires, and the tubular accordion-shaped member 30 is configured with a thin foil formed in an accordion shape. With this configuration, the end portion of the tubular accordion-shaped member 30 does not come apart. Therefore, the tubular accordion-shaped member 30 is not hung up by peripheral members during an attachment work and this facilitates the wiring work.

The tubular accordion-shaped member 30 that is formed with a foil as a whole is less likely to be tore and is tougher compared to the braided wires made by interweaving the thin metal wires. Namely, the tubular accordion-shaped member 30 that is excellent in its durability can surely protect the wires 11 that are inserted therethrough from being in contact with foreign obstacles or adverse effects of peripheral members. Further, the tough tubular accordion-shaped member 30 achieves the shielding property suitable for the metal pipe 21 and therefore, this improves the shielding property of the whole shielding member 20. The main body 32 of the tubular accordion-shaped member 30 is formed in an accordion shape having the projections 32A and the recesses 32B that are arranged alternately. With this configuration, the tubular accordion-shaped member 30 is freely arranged according to the wiring arrangement of the electric wires 11.

The tubular connecting portion 34 of the tubular accordion-shaped member 30 that is clamped to the pipe 21 is formed in a tubular shape that matches the outer peripheral surface 21A of the pipe 21, and this improves workability. The tubular connecting portion 34 is not formed in the accordion shape like the main body 32 and is formed in the tubular shape that matches the outer peripheral surface 21A of the pipe 21. Therefore, a position gap that may be caused between the tubular accordion-shaped member 30 and the pipe 21 or the circular ring-shaped clamp ring 40 is less likely to occur. With this configuration, the tubular accordion-shaped member 30 is surely clamped to the pipe 21, and this improves workability. The tubular connecting portion 34 that is clamped is formed to follow the outer peripheral surface 21A of the pipe 21, and this ensures a large contact area and decreases contact resistance. This ensures electrical connection.

The tubular connecting portion 34 includes the slits 35 that are cut in from the opening end 31 and due to the effects of the slits 35, the tubular accordion-shaped member 30 can decrease its diameter so as to follow the outer peripheral surface 21A of the pipe 21. Accordingly, the tubular connecting portion 34 that is formed in a tubular shape and includes the slits 35 ensures a larger contact area. This also decreases contact resistance and ensures reliable electrical connection. Therefore, the shield conductor 10 according to the present embodiment achieves improved shielding property.

In the portion in which the pipe 21 and the tubular accordion-shaped member 30 are overlapped with each other, the O-ring 22 is fitted to the end portion of the pipe 21 closer to the main body 32 of the tubular accordion-shaped member 30 than the tubular connecting portion 34 that is clamped. The tubular accordion-shaped member 30 includes the tubular seal portion 33 so as to be in closely contact with the O-ring 22. The tubular seal portion 33 forms a step so as to have a diameter greater than the tubular connecting portion 34. With this configuration, the tubular seal portion 33 is closely contacted to the outer peripheral surface 21A of the pipe 21 by the O-ring 22 without having a space therebetween. Therefore, water or foreign obstacles are less likely to intrude through a space between the outer peripheral surface 21A of the pipe 21 and the tubular connecting portion 34 that is clamped with the clamp ring 40.

The end portion of the tubular accordion-shaped member 30 is fitted to a radial outer side of the pipe 21. With this configuration, the end portion of the tubular accordion-shaped member 30 is fitted to the pipe 21 from the radial outer side of the pipe 21, and this facilitates the operation of fitting the pipe 21 into the tubular accordion-shaped member 30.

Each of the slits 35 extends from the opening end 31 of the end portion of the tubular accordion-shaped member 30 along the longitudinal direction of the tubular accordion-shaped member 30 and the slits 35 are formed at equal intervals around the periphery of the opening end 31 of the tubular accordion-shaped member 30. With this configuration, the opening end 31 of the tubular accordion-shaped member 30 evenly reduces its diameter.

The first embodiment is explained. However, the present invention is not limited to the aspects explained in the above embodiment. For example, the following modifications may be included in the present invention. In the following modifications, components same as those in the above embodiment are applied with symbols same as those in the above embodiment and will not explained.

### [First Modification of First Embodiment]

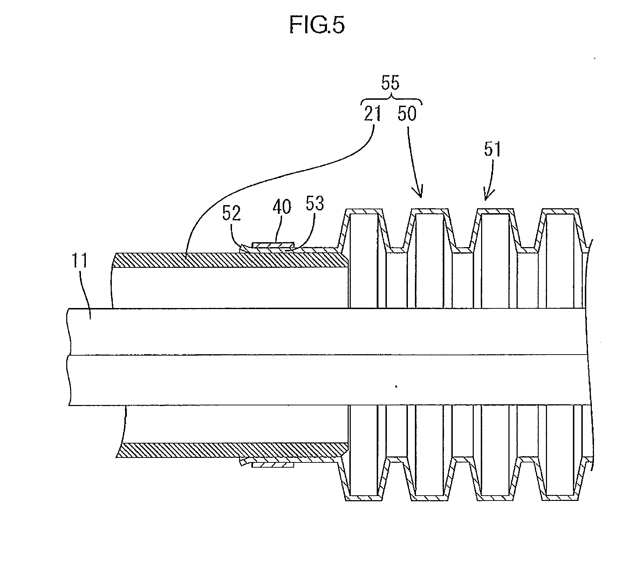

A first modification of the first embodiment will be explained with reference to FIG. 5. Unlike the first embodiment, the O-ring 22 is not fitted to the pipe 21 and the tubular seal portion 33 is not provided to the tubular accordion-shaped member 40 in the first modification.

A tubular accordion-shaped member 50 includes a main body 51 and a tubular connecting portion 53 similar to the first embodiment. The main body 51 is formed in an accordion shape, and the tubular connecting portion 53 extends from the main body 51 to an opening end 52 along the outer peripheral surface 21A of the pipe 21. A portion of the tubular accordion-shaped member 50 that covers the outer peripheral surface 21A of the pipe 21 is the tubular connecting portion 53 that is formed along the outer peripheral surface 21A of the pipe 21. As is not illustrated, a plurality of slits are formed to be cut in from the opening end 52 of the tubular connecting portion 53, and the slits are provided at equal intervals around a circumference of the tubular connecting portion 53.

With such a configuration, the tubular seal portion 33 is not provided and accordingly, the tubular accordion-shaped member 50 is easily molded compared to the first embodiment. A large contact area of the pipe 21 and the tubular accordion-shaped member 50 is ensured, and the contact area is clamped with the clamp ring 40 so as to sufficiently ensure contact reliability between the pipe 21 and the tubular accordion-shaped member 50. This improves the shielding property of the shield member 55 configured with the pipe 21 and the tubular accordion-shaped member 50 against the wires 11.

### <Second Embodiment>

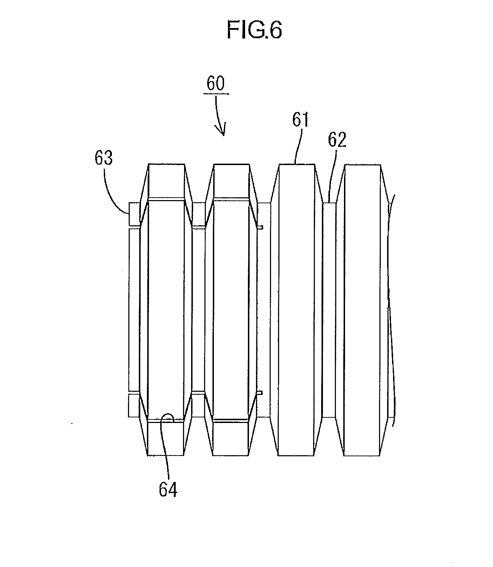

Next, a second embodiment of the present invention will be explained with reference to FIG. 6.

In the second embodiment, the portion of the tubular accordion-shaped member 30 that is clamped with the clamp ring 40 has a shape different from that of the first embodiment. Other configurations are same as those in the first embodiment and will not be explained.

A tubular accordion-shaped member 60 is formed in an accordion shape and projections 61 and recesses 62 are provided alternately over an entire length of the tubular accordion-shaped member 60. A plurality of slits 64 are cut in from an opening end 63 of the tubular accordion-shaped member 60 along the longitudinal direction of the tubular accordion-shaped member 60. An end portion of a pipe (not illustrated) is inserted to the opening end 63 of the tubular accordion-shaped member 60. The slit 64 extends over a portion of the tubular accordion-shaped member 60 that is clamped to the pipe. Namely, a length of the slit 64 in the longitudinal direction of the tubular accordion-shaped member 60 is set such that the tubular accordion-shaped member 60 decreases in its diameter following the outer peripheral surface of the pipe when the tubular accordion-shaped member 60 is clamped to the pipe.

With such a configuration, the tubular accordion-shaped member 60 is formed in the accordion shape over its entire length. Therefore, the tubular connecting portion 34 of the first embodiment is not necessary to be formed and this facilitates a molding work. If the tubular accordion-shaped member 60 is molded in a hose-like shape, a length of the tubular accordion-shaped member 60 can be changed if necessary. With such a configuration, the tubular accordion-shaped member 60 can be widely used. The tubular connecting portion may not be provided to the tubular accordion-shaped member 60 so as to follow the outer peripheral surface of the pipe as the connecting portion connected to the pipe in the first embodiment. Instead, a plurality of slits 64 are formed and the portion of the tubular accordion-shaped member 60 on which the slits 64 are formed can reduce the diameter of the tubular accordion-shaped member 60 so as to follow the outer diameter of the pipe. With this configuration, when the tubular accordion-shaped member 60 is clamped with a clamp ring, it is less likely to occur that the tubular accordion-shaped member 60 does not reduce in its diameter and reliable electrical connection is not established. Because the slits 64 are formed in the tubular accordion-shaped member 60, the tubular accordion-shaped member 60 can reduce its diameter so as to follow the outer diameter of the pipe even if the clamped portion thereof is formed in the accordion shape. Therefore, a sufficient contact area of the tubular accordion-shaped member 60 that is in contact with the pipe is ensured and this lowers contact resistance and ensures sufficient contact reliability.

### <Other Embodiments>

The present invention is not limited to the aspects explained in the above description made with reference to the drawings. The following aspects may be included in the technical scope of the present invention, for example.
(1) In the above embodiments, the number of the electric wires 11 is two or three, however, it may be one, four or more.
(2) In the above embodiments, the pipe 21 has an exact circular cross sectional shape, however, the pipe 21 may be modified to have an elongated cross section such as an ellipsoidal cross section according to a wiring condition.
(3) In the above embodiments, no plate processing is applied to the clamped portion including the outer peripheral surface 21A of the pipe 21 and the tubular connecting portion 34 of the tubular accordion-shaped member 30 for anticorrosion or protecting from electric corrosion. However, the end portion of the pipe 21 may be galvanized to achieve its anticorrosion. A contact surface of the tubular accordion-shaped member 30 that comes in contact with the pipe 21 may be tin-plated such that electric corrosion is less likely to be caused. The electric corrosion may be caused by contact of metals of different kinds.
(4) In the above embodiments, the pipe 21 is made of metal such as aluminum or aluminum alloy, and the tubular accordion-shaped member 30 is made of metal such as copper or copper alloy that has excellent flexibility. However, the pipe 21 and the tubular accordion-shaped member 30 may be configured with other different metals or conductive materials other than metals.
(5) In the above embodiments, the tubular accordion-shaped member 30 and the pipe 21 are clamped with the clamp ring 40 formed in a ring-shape to electrically connect the pipe 21 and the tubular accordion-shaped member 30. However, they may be clamped with a clamp ring formed in a C-shape. The pipe and the tubular accordion-shaped member may be tightened up from their outer periphery by a tightening member such as a banding band.

### EXPLANATION OF SYMBOLS

- 10:: Shield conductor
- 11:: Electric wires
- 20:: Shield member
- 21:: Pipe
- 21A:: Outer peripheral surface
- 22:: O-ring (Seal ring)
- 30:: Tubular accordion-shaped member
- 31:: Opening end
- 32:: Main body
- 33:: Tubular seal portion
- 34:: Tubular connecting portion
- 35:: Slit
- 40:: Clamp ring (Tightening ring)

## Claims

1. A shield conductor comprising:
a wire;
a tubular shield member including a metal pipe and a metal tubular accordion-shaped member, the tubular shield member surrounding the wire, and an end portion of the metal pipe fitted to an end portion of the tubular accordion-shaped member;
a tightening ring provided to a portion of the tubular accordion-shaped member to which the end portion of the pipe is fitted, and configured to tight the end portion of the pipe and the end portion of the tubular accordion-shaped member from an outer peripheral side, wherein
the tubular accordion-shaped member has at least one slit in a portion thereof that is configured to be tightened by the tightening ring, the slit is formed by cutting in from an opening end of the tubular accordion-shaped member.

2. The shield conductor according to claim 1, wherein the end portion of the tubular accordion-shaped member is provided on a radial outer side of the pipe.

3. The shield conductor according to claim 2, wherein the portion of the tubular accordion-shaped member that is configured to be tightened to an outer periphery of the pipe includes a tubular connecting portion that is formed along the outer periphery of the pipe.

4. The shield conductor according to any one of claims 1 to 3, wherein
a portion of the tubular accordion-shaped member that is provided continuously from the tubular connecting portion includes a tubular seal portion that has a diameter greater than the tubular connecting portion and forms a step having a circular gap between the pipe and the tubular seal portion, and
a seal ring is provided in the circular gap between the pipe and the tubular seal portion.

5. The shield conductor according to any one of claims 1 to 4, wherein the slit extends from the opening end of the end portion of the tubular accordion-shaped member along a longitudinal direction of the tubular accordion-shaped member, and the slit including a plurality of slits that are provided at equal intervals around a circumferential direction of the opening end of the tubular accordion-shaped member.
